# EUROPÄISCHE PATENTSCHRIFT

(11) **EP 3 619 542 B1**
(45) Veröffentlichungstag und Bekanntmachung des Hinweises auf die Patenterteilung: **07.06.2023**
(21) Anmeldenummer: 19715909.8
(22) Anmeldetag: 04.04.2019
(51) Int. Cl.: G01R 3/00, G01R 1/073

(54) **VERFAHREN ZUM REINIGEN DER NADELSPITZEN DER NADELN VON NADELKARTEN**
METHOD FOR CLEANING THE NEEDLE TIPS OF THE NEEDLES OF NEEDLE CARDS
PROCÉDÉ DE NETTOYAGE DES POINTES D'AIGUILLES DE CARTES À AIGUILLES

(30) Priorität: 09.04.2018 AT 962018
(43) Veröffentlichungstag der Anmeldung: 11.03.2020
(73) Patentinhaber: Gaggl, Rainer, 9580 Drobollach (AT)
(72) Erfinder: Gaggl, Rainer, 9580 Drobollach (AT)
(74) Vertreter: Beer & Partner Patentanwälte KG
(86) Internationale Anmeldenummer: PCT/EP2019/058489
(87) Internationale Veröffentlichungsnummer: WO 2019/197267

(56) Entgegenhaltungen:
- EP-A2- 0 864 871
- KR-A- 20120 062 317
- US-A1- 2003 138 644
- N.A. N.A.: "Proble Lap PCC PD-PLG02", , 13. Februar 2018 (2018-02-13), Seiten 1-2, XP055597063, Gefunden im Internet: URL:https://www.inttest.net/wp-content/upl oads/2018/02/its_pcc_pd-plg02.pdf [gefunden am 2019-06-17]
- Jerry Broz ET AL: "Probe Card Cleaning Probe Card Cleaning " " A Short Tutorial A Short Tutorial " "", IEEE SW Test Workshop, 6. Juni 2007 (2007-06-06), Seiten 1-81, XP055597000, San Diego, CA USA Gefunden im Internet: URL:https://www.swtest.org/swtw_library/20 07proc/PDF/T00_01_Broz_SWTW2007.pdf [gefunden am 2019-06-17]

## Beschreibung

Die Erfindung betrifft ein Verfahren zum Reinigen der Nadelspitzen der Nadeln von Nadelkarten.

Nadelkarten sind bei ihrer Verwendung in eine in der Regel automatische Vorrichtung ("Wafer-Prober") eingespannt, welche das mechanische Zuführen der zu testenden Halbleiterbauelemente ("Chips") an die Nadelkarte übernimmt - das sogenannte "Kontaktieren". Diese bekannten Vorrichtungen bewegen üblicherweise die Halbleiterscheiben, auf denen sich die zu prüfenden Chips befinden, zur Nadelkarte hin.

Es gibt auch Vorrichtungen, die bereits vereinzelte Chips oder bereits gesägte Wafer mit der Nadelkarte kontaktieren. Solche Vorrichtungen werden beispielsweise als "Chip-Handler" bzw. "Frame-Prober" bezeichnet.

Durch das vielfache Kontaktieren der Nadeln der Nadelkarte mit den Halbleiterbauelementen (Chips) verschmutzen die Nadelspitzen beispielsweise durch Metallpartikel, die Abrieb von Kontaktflächen der Halbleiterbauelemente (Chips) sind. Dies verschlechtert die elektrischen Kontakteigenschaften der Nadelkarten, was beispielsweise einen erhöhten Kontaktwiderstand und damit einhergehend einen Ausfall der elektrischen Prüfung der Halbleiterbauelemente (Chips) zur Folge hat.

Um die Kontakteigenschaften der Nadeln von Nadelkarten während des Einsatzes "sicherzustellen", wird bei den bekannten Vorrichtungen ein - in der Regel automatisiertes - Reinigen der Spitzen der Nadeln an einer Reinigungseinheit ("cleaning chuck" oder "cleaning unit") durchgeführt. Hierbei werden die Nadelspitzen mit Reinigungsmedien, wie beispielsweise feinsten Schleifpapieren, keramischen Schleifsteinen oder auch weichen, mit einer gelartigen Oberfläche versehenen Reinigungsfolien ("cleaning pads"), leicht angeschliffen, sodass die Kontaktflächen der Nadeln im Bereich der Nadelspitzen wieder metallisch blank werden. Reinigungsfolien ("gel polish pads") besitzen zusätzlich die Eigenschaft, dass diese durch die leicht klebrige Gel-Oberfläche, in welche die zu reinigende Nadel einsticht, verunreinigende Partikel von der Nadel entfernen und in der Gel-Oberfläche zurückhalten, indem sie die Partikel einbetten.

Ein derartiger Vorschlag ist in KR 20120062317 A enthalten. KR 20120062317 A erwähnt, dass ein Reinigungspad den Nachteil hat, dass auf dem Reinigungspad vorhandene Verunreinigungen auf Prüfnadeln übertragen werden können. Um diesem Problem Rechnung zu tragen, schlägt KR 20120062317 A vor, eine Reinigungsstation für Prüfnadeln vorzusehen, in der die Prüfnadeln mit Hilfe einer Laser-Apparatur gereinigt werden.

Die Stellen, an welchen die Nadelspitzen der Nadelkarte auf den Reinigungsmedien aufsetzen ("Reinigungspositionen"), werden in regelmäßigen - mit in der Regel gleichmäßigen - Abständen voneinander geändert, sodass die Fläche der Reinigungsmedien möglichst gleichmäßig abgenutzt wird. Üblicherweise ist die Bewegungsrichtung zwischen aufeinanderfolgenden Reinigungspositionen unter einem Winkel von etwa 45° zu den Hauptachsen der Nadelanordnung ausgerichtet. Reinigungspositionen werden solange in dieser Richtung weiterversetzt, bis mit der Nadelkarte der Rand des Reinigungsmediums erreicht worden ist. Dann wird die Bewegungsrichtung um 90° geändert und die Reinigungspositionen werden weiter versetzt, bis der nächste Rand des Reinigungsmediums erreicht ist. Auch andere Bewegungsmuster für Reinigungspositionen sind üblich, beispielsweise streifenförmige, versetzte Bahnen der Bewegungen.

Der gleichmäßige Versatz zwischen den einzelnen Reinigungspositionen führt jedoch dazu, dass je nach Periodizität dieses Versatzes einzelne Nadelspitzen einer Nadelkarte mit bereits von anderen Nadeln benutzten Stellen des Reinigungsmediums in Berührung kommen. Es sind dies jene Nadelspitzen, die in der Abfolge des Aufsetzens auf das Reinigungsmedium relativ zur Bewegungsrichtung des Reinigungsmusters anderen Nadeln nachfolgen. Die Häufigkeit des Auftretens dieses nachteiligen Effektes hängt vom Abstand der Nadeln und von der Schrittweite des Bewegungsmusters des Versatzes der Nadeln relativ zu dem Reinigungsmedium ab. Dieser Effekt führt bei Nadeln, die in bereits "benutzten" Reinigungspositionen (Berührungsstellen) mit dem Reinigungsmedium in Berührung kommen, zu einer verminderten Wirkung des Reinigens oder Schleifens der Nadelspitzen.

Dies kann nicht nur das ganze Nadelensemble einer Nadelkarte betreffen, sondern auch nur einzelne Nadeln, bei welchen der Nadelabstand in Bewegungsrichtung des Reinigungsmusters und der Schrittweite des Reinigungsmusters gemeinsame Vielfache bilden (Moire-Effekt).

Das im Stand der Technik auftretende, systematisch ungleichmäßige Reinigen einzelner Nadeln einer Nadelkarte führt beim elektrischen Prüfen von Halbleiterbauelementen durch sogenannten "Kontaktausfall" zu Fehlern.

Dieser nachteilige Effekt führt auch zu einem unterschiedlichen Verschleiß einzelner Nadelspitzen einer Nadelkarte, da das Reinigen der Spitzen durch die Abrasion Material von den Nadelspitzen abträgt.

Der nachteilige Effekt des ungleichmäßigen Reinigens wird umso größer, je höher die Anzahl der Nadeln in einer Nadelkarte ist, und ist stark ausgeprägt, wenn die Nadeln in der Nadelkarte geometrisch gleichmäßig angeordnet sind, wie dies häufig der Fall ist.

Der Erfindung liegt die Aufgabe zugrunde, ein Verfahren der eingangs genannten Gattung anzugeben, welches die beschriebenen Nachteile herkömmlicher Verfahren nicht aufweist.

Gelöst wird diese Aufgabe erfindungsgemäß mit einem Verfahren, das die Merkmale von Anspruch 1 aufweist.

Bevorzugte und vorteilhafte Ausgestaltungen des erfindungsgemäßen Verfahrens sind Gegenstand der Unteransprüche.

Bei dem erfindungsgemäßen Verfahren wird das bisher übliche geometrisch periodische Schrittmuster zwischen den einzelnen Reinigungsvorgängen (Reinigungspositionen) durch ein zufälliges Schrittmuster ersetzt. Bei dem erfindungsgemäßen Verfahren wird die Richtung des Versatzes der Bewegung zwischen aufeinanderfolgenden Reinigungspositionen jeweils zufällig gewählt.

Weiters kann bei dem erfindungsgemäßen Verfahren die Größe der Schritte zwischen aufeinanderfolgenden Reinigungspositionen zufällig gewählt werden.

Bei dem erfindungsgemäßen Verfahren wird das Muster (insbesondere Richtung und Größe) der Schritte zwischen aufeinanderfolgenden Reinigungspositionen nicht systematisch, sondern zufällig gewählt.

Durch das erfindungsgemäße Verfahren ist die geometrische Periodizität von Reinigungspositionen zueinander gebrochen und das im Stand der Technik systematisch mangelhafte Reinigen einzelner oder mehrerer Nadeln in einem Nadelensemble einer Nadelkarte tritt bei dem erfindungsgemäßen Verfahren nicht mehr auf.

Von besonderem Vorteil ist es bei dem erfindungsgemäßen Verfahren, dass es nicht mehr zu einem systematisch schlechteren Reinigen einzelner Nadeln oder mehrerer Nadeln im Nadelensemble einer Nadelkarte kommen kann.

Wenn bei dem erfindungsgemäßen Verfahren einzelne Nadeln in Reinigungspositionen auf das Reinigungsmedium auftreffen, die bereits von anderen Nadeln benutzt worden sind, ist das kein Nachteil, weil dies durch den zufallsbehafteten Versatz der Reinigungspositionen im Mittel für alle Nadeln mit annähernd gleicher Wahrscheinlichkeit auftritt, und es daher nicht mehr zu einem systematisch schlechteren Reinigen einzelner oder mehrerer Nadeln des Nadelensembles der Nadelkarte kommen kann.

In einer bevorzugten Ausführungsform des erfindungsgemäßen Verfahrens ist vorgesehen, dass nach jedem Reinigungsschritt sequentiell die gesamte Fläche des Reinigungsmediums (Reinigungsplatte) wieder als geometrisch möglicher Zielpunkt der zufälligen Abfolge von Reinigungspositionen zur Verfügung steht (random cleaning pattern).

Bei dem erfindungsgemäßen Verfahren ist vorgesehen, dass ein regelmäßiges periodisches Fortschreiten des Musters der Schritte zwischen aufeinanderfolgenden Reinigungspositionen mit einer Zufallsfunktion überlagert wird (pseudo random cleaning pattern).

Der Wertebereich der Zufallsfunktion kann der periodischen Schrittweite entsprechen - damit wird die Schwankungsbreite der Einzelschritte zwischen aufeinanderfolgenden Reinigungspositionen auf höchstens die Periode des zugrundliegenden regelmäßigen Musters dieser Schritte beschränkt. Damit ist bei dem erfindungsgemäßen Verfahren einerseits die Zufälligkeit der Folge der Schritte zwischen aufeinanderfolgenden Reinigungspositionen gegeben und anderseits sind kurze Wege (Schrittlängen) zwischen aufeinanderfolgenden Reinigungspositionen möglich. Dies macht das erfindungsgemäße Verfahren in Bezug auf den Bewegungsablauf und die dazu benötigte Zeit effizient.

Weitere Einzelheiten, Merkmale und Vorteile des erfindungsgemäßen Verfahrens ergeben sich aus nachstehender Beschreibung, in welcher auf die beispielhaften Zeichnungen Bezug genommen wird. Es zeigt:
- Fig. 1: ein bekanntes regelmäßiges Muster von Reinigungspositionen an einem Reinigungsmedium,
- Fig. 2: ein unregelmäßiges Muster (erfindungsgemäß) der Abfolge von Reinigungspositionen am Reinigungsmedium und
- Fig. 3: eine andere Ausführungsform eines unregelmäßigen Musters (erfindungsgemäß) von Reinigungspositionen am Reinigungsmedium.

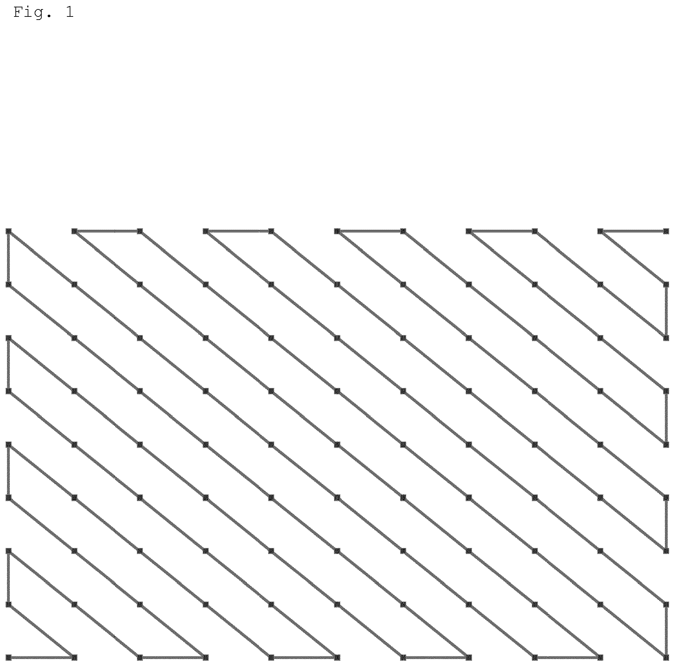

Fig. 1 zeigt ein regelmäßiges (bekanntes) Muster der Abfolge der Reinigungspositionen an einem Reinigungsmedium (Reinigungspad). Die Reinigungspositionen, an welchen die Nadelspitzen der Nadelkarte auf das Reinigungsmedium aufgesetzt werden, haben regelmäßige, gleichmäßige Abstände voneinander. Die Richtung der Schritte zwischen aufeinanderfolgenden Reinigungspositionen ist unter einem Winkel von 45° zu den Hauptachsen der Chipposition ausgerichtet.

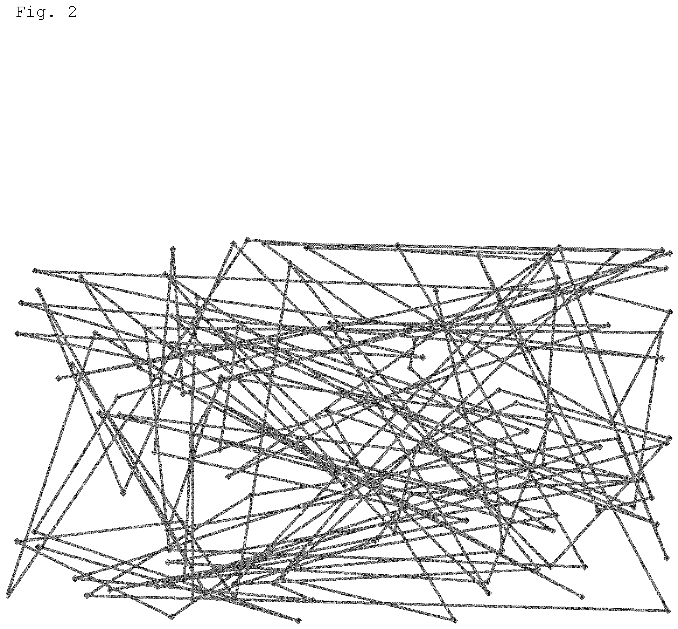

Fig. 2 zeigt ein unregelmäßiges Muster (random pattern) der Abfolge der Reinigungspositionen am Reinigungsmedium. Die Reinigungspositionen sind so gewählt, dass sequentiell nach jedem Reinigungsschritt die gesamte Fläche der Reinigungsplatte wieder als geometrisch möglicher Zielpunkt der nächsten Reinigungsposition in der zufälligen Abfolge der Schritte zwischen Reinigungspositionen zur Verfügung steht.

Es ist erkennbar, dass bei dem Muster der Reinigungspositionen von Fig. 2 zwischen einzelnen Reinigungspositionen relativ große Schritte auftreten können.

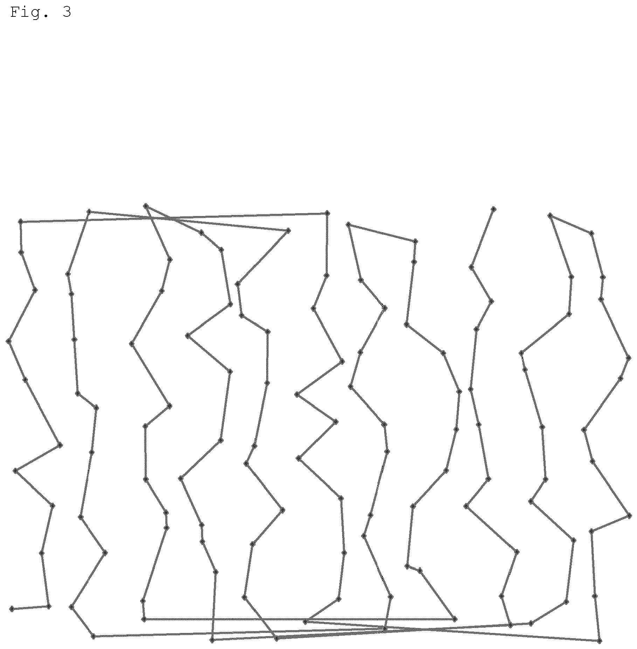

Bei dem unregelmäßigen Muster der Abfolge von Schritten zwischen aufeinanderfolgende Reinigungspositionen auf dem Reinigungsmedium, wie dies in Fig. 3 dargestellt ist, ergeben sich kürzere Schritte zwischen aufeinanderfolgenden Reinigungspositionen, weil das regelmäßig und periodisch fortschreitende Reinigungsmuster mit einer Zufallsfunktion überlagert ist (pseudo random pattern).

Der Wertebereich der überlagerten Zufallsfunktion kann beispielsweise gleich der periodischen Schrittlänge sein.

Bei dem in Fig. 3 gezeigten Muster der Schritte zwischen aufeinanderfolgenden Reinigungspositionen ist die Zufälligkeit der Bewegungsabfolge gegeben und überdies werden kurze Schritte zwischen aufeinanderfolgenden Reinigungspositionen erreicht.

Hinzuweisen ist darauf, dass die in den Fig. 2 und 3 gezeigten Muster der Abfolge von Schritten zwischen aufeinanderfolgenden Reinigungspositionen auf dem Reinigungsmedium nur beispielhaft sind, da auch andere Wertebereiche der Zufallsfunktion in Bezug auf die Periodizität des Grundmusters beim erfindungsgemäßen Verfahren möglich sind.

Die Bewegungen der Nadeln der Nadelkarte relativ zum Reinigungsmedium, um die Schritte zwischen den Reinigungspositionen auszuführen, können bei dem erfindungsgemäßen Verfahren mit Vorteil und beispielhaft und bevorzugt dadurch ausgeführt werden, dass nicht die Nadelkarte, sondern das Reinigungsmedium bewegt wird.

Zusammenfassend kann ein Ausführungsbeispiel der Erfindung wie folgt beschrieben werden:
Beim Reinigen der Spitzen von Nadeln von Nadelkarten werden die Spitzen der Nadeln in ein Reinigungsmedium in verschiedenen Reinigungspositionen in Wirkkontakt gebracht, um von den Spitzen der Nadeln Verunreinigungen zu entfernen und die Spitzen der Nadeln blank zu machen. Die Lage der Reinigungspositionen und die Richtung des Versetzens der Nadelkarte zwischen aufeinanderfolgenden Reinigungspositionen werden zufällig gewählt.

## Patentansprüche

1. Verfahren zum Reinigen von Nadeln einer Nadelkarte, bei dem die Spitzen der Nadeln mit einem Reinigungsmedium in voneinander beabstandeten Reinigungspositionen in Berührung gebracht werden und bei dem die Reinigungspositionen nach einem Muster über die Fläche des Reinigungsmedium verteilt werden, **dadurch gekennzeichnet, dass** das Muster der Reinigungspositionen zufällig gewählt wird, wobei das Muster der Schritte zwischen aufeinanderfolgenden Reinigungspositionen als ein regelmäßig fortschreitendes und periodisches Muster gewählt wird, das durch eine Zufallsfunktion überlagert wird.

2. Verfahren zum Reinigen von Nadeln einer Nadelkarte nach Anspruch 1, **dadurch gekennzeichnet, dass** die Schrittlängen zwischen aufeinanderfolgenden Reinigungspositionen zufällig und mit voneinander unterschiedlichen Größen gewählt werden.

3. Verfahren zum Reinigen von Nadeln einer Nadelkarte nach Anspruch 1 oder 2, **dadurch gekennzeichnet, dass** die Richtung der Schritte zwischen aufeinanderfolgenden Reinigungspositionen zufällig gewählt wird.

4. Verfahren nach einem der Ansprüche 1 bis 3, **dadurch gekennzeichnet, dass** sequentiell nach jedem Reinigungsschritt die gesamte Fläche des Reinigungsmediums als geometrisch möglicher Ort für die nachfolgende Reinigungsposition vorgesehen wird.

5. Verfahren zum Reinigen von Nadeln einer Nadelkarte nach Anspruch 1, **dadurch gekennzeichnet, dass** der Wertebereich der Zufallsfunktion entsprechend der periodischen Schrittlänge gewählt wird.

## Claims

1. Method for cleaning needles of a needle card, in which the tips of the needles are brought into contact with a cleaning medium in cleaning positions spaced apart from each other, and in which the cleaning positions are distributed according to a pattern over the surface of the cleaning medium, **characterized in that** the pattern of the cleaning positions is selected at random, whereby the pattern of steps between consecutive cleaning positions is selected as a regularly progressing and periodic pattern that is superposed by a random function.

2. Method for cleaning needles of a needle card according to claim 1, **characterized in that** the step lengths between consecutive cleaning positions are selected at random and with sizes that differ from each other.

3. Method for cleaning needles of a needle card according to claim 1 or 2, **characterized in that** the direction of the steps between consecutive cleaning positions is selected at random.

4. Method according to one of claims 1 to 3, **characterized in that** the entire surface of the cleaning medium is sequentially provided as a geometrically possible location for the subsequent cleaning position after each cleaning step.

5. Method for cleaning needles of a needle card according to claim 1, **characterized in that** the value range of the random function is selected according to the periodic step length.

## Revendications

1. Procédé de nettoyage d'aiguilles d'une carte à aiguilles, dans lequel les pointes des aiguilles sont mises en contact avec un milieu de nettoyage dans des positions de nettoyage espacées les unes des autres et dans lequel les positions de nettoyage sont réparties selon un motif sur la surface du milieu de nettoyage, **caractérisé en ce que** le motif des positions de nettoyage est choisi de manière aléatoire, le motif des pas entre des positions de nettoyage successives étant choisi sous la forme d'un motif régulièrement progressif et périodique, auquel est superposée une fonction aléatoire.

2. Procédé de nettoyage d'aiguilles d'une carte à aiguilles selon la revendication 1, **caractérisé en ce que** les longueurs de pas entre des positions de nettoyage successives sont choisies de manière aléatoire et avec des tailles différentes les unes des autres.

3. Procédé de nettoyage d'aiguilles d'une carte à aiguilles selon la revendication 1 ou 2, **caractérisé en ce que** la direction des pas entre des positions de nettoyage successives est choisie de manière aléatoire.

4. Procédé selon l'une des revendications 1 à 3, **caractérisé en ce que**, séquentiellement après chaque pas de nettoyage, la totalité de la surface du milieu de nettoyage est prévue comme emplacement géométriquement possible pour la position de nettoyage suivante.

5. Procédé de nettoyage d'aiguilles d'une carte à aiguilles selon la revendication 1, **caractérisé en ce que** la plage de valeurs de la fonction aléatoire est choisie en fonction de la longueur de pas périodique.
